# EUROPEAN PATENT APPLICATION

(11) **EP 4 730 930 A1**
(43) Date of publication of application: **22.04.2026**
(21) Application number: 23944262.7
(22) Date of filing: 03.07.2023
(51) Int. Cl.: H05K 5/04, H05K 7/04, H05K 7/06, H05K 9/00

(54) **STRUCTURE**

(71) Applicant: MITSUBISHI ELECTRIC CORPORATION, Chiyoda-ku Tokyo 100-8310 (JP)
(72) Inventor: HIROSE, Kenji, Tokyo 100-8310 (JP); OTSUKA, Kyota, Tokyo 100-8310 (JP); HAGIWARA, Kaito, Tokyo 100-8310 (JP); AKASHI, Norihiko, Tokyo 100-8310 (JP)
(74) Representative: Pfenning, Meinig & Partner mbB
(86) International application number: PCT/JP2023/024540
(87) International publication number: WO 2025/009008

(57) **Abstract**

A structure formed by placing a plurality of metal sheets (10, 20) one on another in a sheet-thickness direction, the plurality of metal sheets (10, 20) each having an electrically conductive base material covered with an insulating coating, the structure including: a protrusion (11) provided on a first metal sheet (10) of the plurality of metal sheets (10, 20) that are adjacent to each other and are fastened together with a screw (51), the protrusion protruding toward a second metal sheet (20); an elastically deformable portion (12) provided on the metal sheet (10) in such a manner that the elastically deformable portion (12) surrounds the protrusion (11), the elastically deformable portion (12) being elastically deformable at the time of the fastening with the screw (51); a protrusion (21) disposed on the metal sheet (20) in such a manner that the protrusion (21) protrudes toward the metal sheet (10), and crosses the protrusion (11); and an elastically deformable portion (22) provided on the metal sheet (20) in such a manner that the elastically deformable portion (22) surrounds the protrusion (21), the elastically deformable portion (22) being elastically deformable at the time of the fastening with the screw (51). The end of the first protrusion (11) and the end of the second protrusion (21) contact each other at the time of the fastening with the screw (51).

## Description

### TECHNICAL FIELD

The present disclosure relates to a structure.

### BACKGROUND ART

Metal sheets are used for the housing of an electronic device in some cases. In this case, a measure against noise current or leakage current is taken by enhancing the electrical connectivity between the metal sheets, in some cases. In view of this, Patent Literature 1 discloses a technology for enhancing the electrical connectivity between metal sheets forming a structure.

### CITATION LIST

### PATENT LITERATURE

Patent Literature 1: Japanese Unexamined Utility Model (Registration) Application Publication No. S47-18727

### SUMMARY OF INVENTION

### TECHNICAL PROBLEM

In the structure disclosed in Patent Literature 1, crests and roots are arranged alternately on respective facing surfaces of the metal sheets. At this time, crests and roots of a first metal sheet and crests and roots of a second metal sheet are arranged in such a manner that they cross each other. By screwing the metal sheets together with a screw in such a state, the ends of facing crests contact each other, and crush each other. Because of this, insulating coatings are peeled off from the crushed portions. As a result, the base materials (conductors) of the respective metal sheets contact each other, and are electrically connected with each other.

However, since a screw is used to fasten the metal sheets together in the structure disclosed in Patent Literature 1, there is a risk that the electrical connection between the base materials may be lost if the screw loosens undesirably for some reason.

The present disclosure has been made to solve the problem described above, and an object thereof is to provide a structure that can ensure electrical connection between the base materials of metal sheets even when a fastening member loosens undesirably.

### SOLUTION TO PROBLEM

A structure according to the present disclosure is a structure formed by placing a plurality of metal sheets one on another in a sheet-thickness direction, the plurality of metal sheets each having an electrically conductive base material covered with an insulating coating, the structure comprising: a first protrusion provided on a first metal sheet of the plurality of metal sheets that are adjacent to each other and are fastened together with a fastening member, the first protrusion protruding toward a second metal sheet of the plurality of metal sheets; a first elastically deformable portion provided on the first metal sheet in such a manner that the first elastically deformable portion surrounds a periphery of the first protrusion, the first elastically deformable portion being elastically deformable at the time of the fastening with the fastening member; a second protrusion disposed on the second metal sheet in such a manner that the second protrusion protrudes toward the first metal sheet, and crosses the first protrusion; and a second elastically deformable portion provided on the second metal sheet in such a manner that the second elastically deformable portion surrounds a periphery of the second protrusion, the second elastically deformable portion being elastically deformable at the time of the fastening with the fastening member, wherein an end of the first protrusion and an end of the second protrusion contact each other at the time of the fastening with the fastening member.

### ADVANTAGEOUS EFFECTS OF INVENTION

According to the present disclosure, electrical connection between the base materials of metal sheets can be ensured even when a fastening member loosens undesirably. Because of this, it becomes unnecessary to use a special screw, washer, or the like for electrically connecting the base materials of the metal sheets.

### BRIEF DESCRIPTION OF DRAWINGS

FIGS. 1A to 1C are schematic configuration diagrams of a structure according to a first embodiment.
FIG. 1A is a front view of the structure according to the first embodiment.
FIG. 1B is a drawing of a first metal sheet as seen from the front-surface side.
FIG. 1C is a drawing of a second metal sheet as seen from the rear-surface side.
FIGS. 2A and 2B are schematic perspective views of the structure according to the first embodiment.

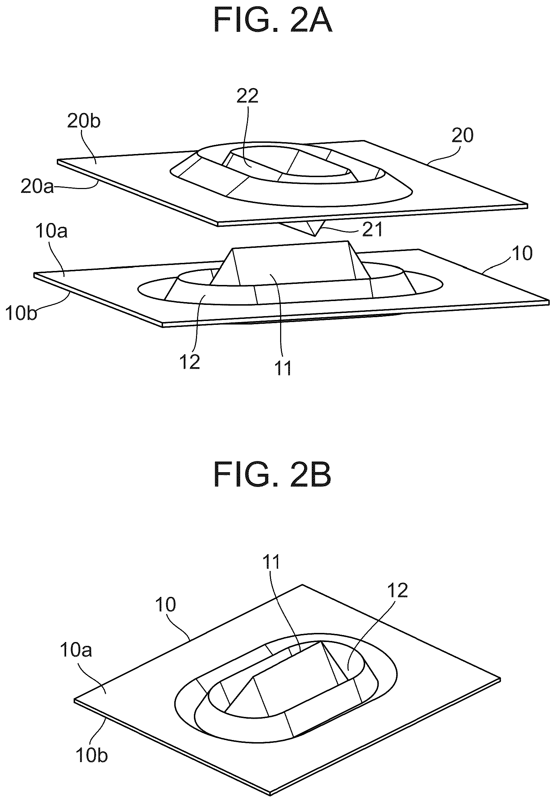

FIG. 2A is a perspective view of the structure according to the first embodiment.
FIG. 2B is a perspective view of the first metal sheet.

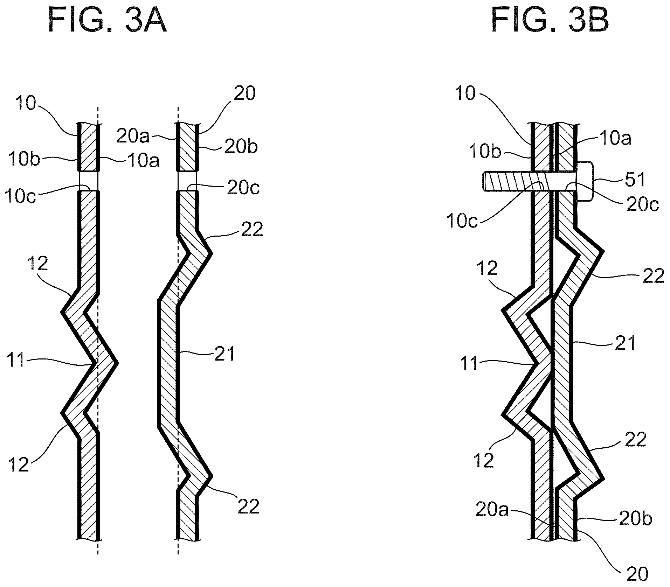

FIGS. 3A and 3B are drawings illustrating operation to fasten the structure according to the first embodiment.
FIG. 3A is a cross-sectional view illustrating a state before the first metal sheet and the second metal sheet are fastened.
FIG. 3B is a cross-sectional view illustrating a state after the first metal sheet and the second metal sheet are fastened.

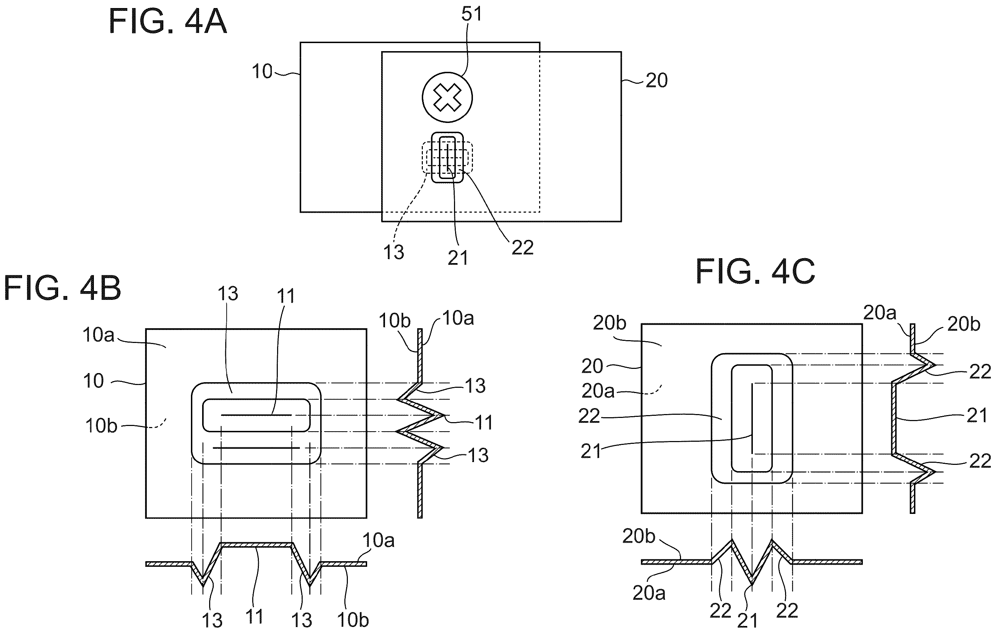

FIGS. 4A to 4C are schematic configuration diagrams of a structure according to a second embodiment.
FIG. 4A is a front view of the structure according to the second embodiment.
FIG. 4B is a drawing of a first metal sheet as seen from the front-surface side.
FIG. 4C is a drawing of a second metal sheet as seen from the rear-surface side.

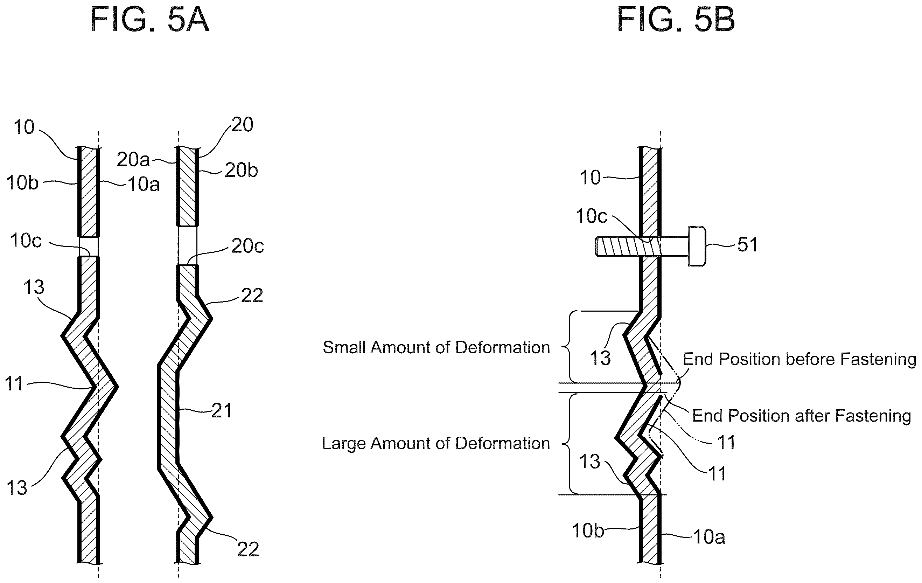

FIGS. 5A and 5B are drawings illustrating operation to fasten the structure according to the second embodiment.
FIG. 5A is a cross-sectional view illustrating a state before the first metal sheet and the second metal sheet are fastened.
FIG. 5B is a cross-sectional view illustrating a state after the first metal sheet is fastened with the second metal sheet.

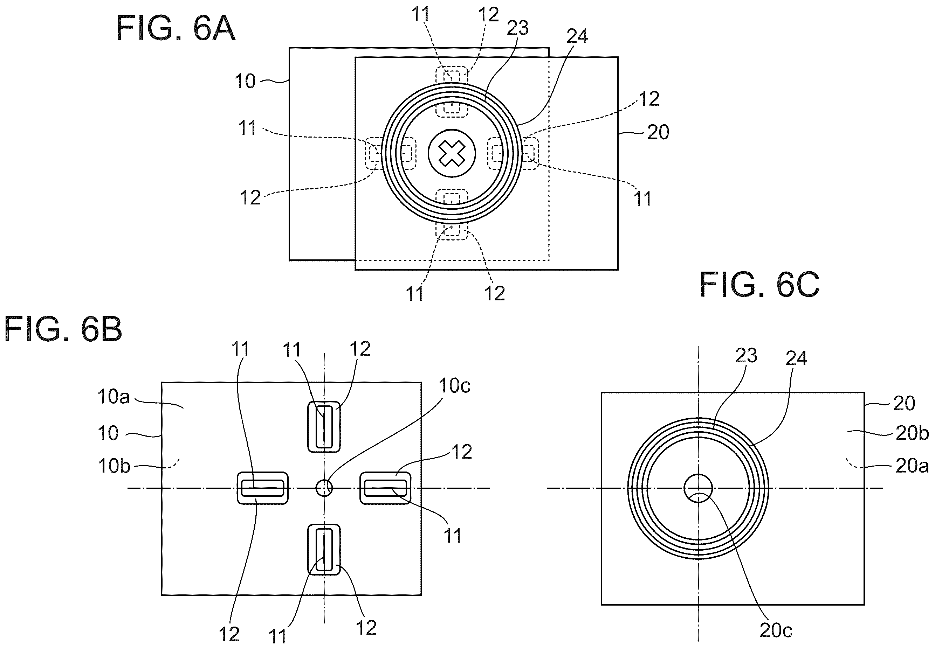

FIGS. 6A to 6C are schematic configuration diagrams of a structure according to a third embodiment.
FIG. 6A is a front view of the structure according to the third embodiment.
FIG. 6B is a drawing of a first metal sheet as seen from the front-surface side.
FIG. 6C is a drawing of a second metal sheet as seen from the rear-surface side.

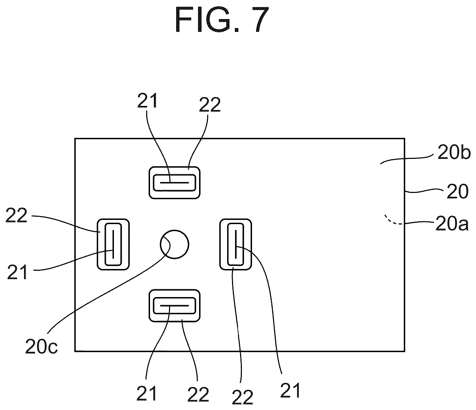

FIG. 7 is a drawing of another second metal sheet in the structure according to the third embodiment as seen from the rear side.

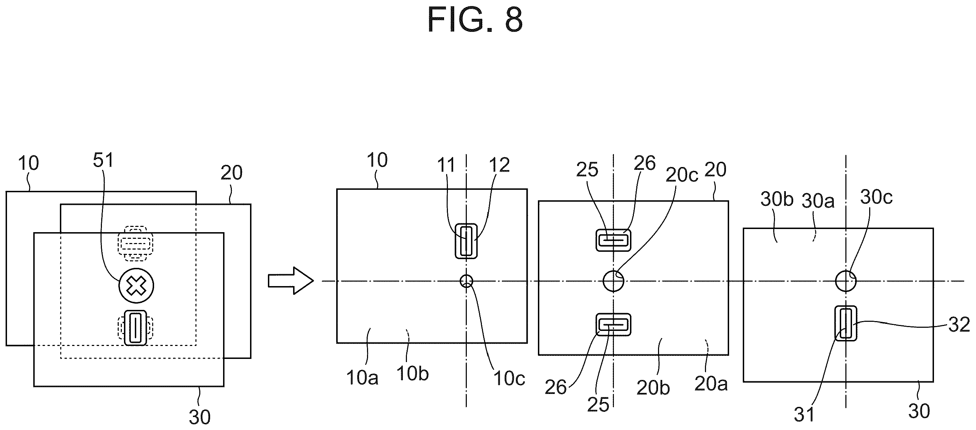

FIG. 8 is a schematic configuration diagram of a structure according to a fourth embodiment.

### DESCRIPTION OF EMBODIMENTS

Hereinafter, embodiments of the present disclosure are explained with reference to the attached drawings in order to explain the present disclosure in more detail.

### First Embodiment.

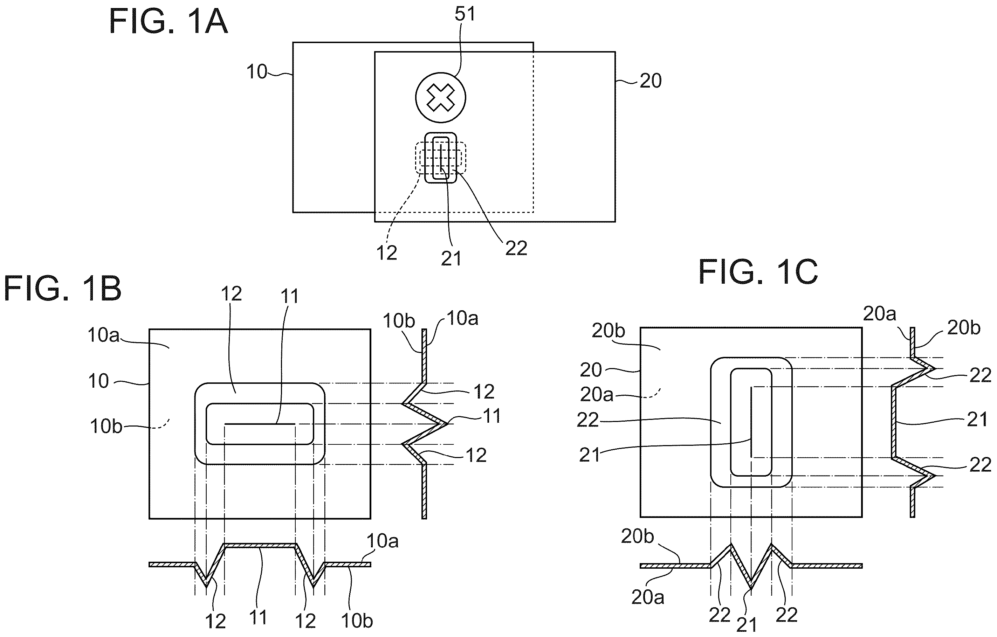

A structure according to a first embodiment is explained using FIGS. 1 to 3.

First, the configuration of the structure according to the first embodiment is explained using FIGS. 1 to 3. FIG. 1 is schematic configuration diagrams of the structure according to the first embodiment. FIG. 2 is schematic perspective views of the structure according to the first embodiment. FIG. 3 is drawings illustrating operation to fasten the structure according to the first embodiment.

As illustrated in FIG. 1A and FIG. 2A, for example, the structure according to the first embodiment is applied between two metal sheets 10 and 20 among a plurality of metal sheets forming the housing (illustration omitted) of an electronic device. The metal sheets 10 and 20 are overlapped with each other in the sheet-thickness direction.

Each of the metal sheets 10 and 20 includes: an electrically conductive base material; and an insulating coating (the surface layers of the metal sheets 10 and 20) formed on the front surface and rear surface of the base material, and having an insulation property. For example, the base material is a conductor such as a metal. In addition, for example, the insulating coating is a paint coating, a protective coating, or the like for preventing corrosion.

Portions of the first metal sheet 10 and the second metal sheet 20 are placed one on another to face each other, and the facing portions are fastened with a screw 51. This screw 51 is included in a fastening member. Note that there are no problems even if the fastening member is a rivet, a snap-fit, or the like.

As illustrated in FIGS. 1 and 2, the metal sheet 10 includes a protrusion 11 and an elastically deformable portion 12. The protrusion 11 and the elastically deformable portion 12 are provided in an area of the metal sheet 10 where the metal sheet 10 faces the metal sheet 20.

As illustrated in FIG. 3, the metal sheet 10 has a front surface 10a, a rear surface 10b, and a screw hole 10c. The front surface 10a is a facing surface facing the metal sheet 20. The rear surface 10b is a surface positioned on a side opposite to the front surface 10a. The screw hole 10c penetrates the metal sheet 10 in the sheet-thickness direction. That is, the screw hole 10c is opened at the front surface 10a and the rear surface 10b. This screw 51 can be screwed into the screw hole 10c.

The protrusion 11 protrudes outward from the front surface 10a of the metal sheet 10. In other words, the protrusion 11 protrudes toward the metal sheet 20 from the front surface 10a of the metal sheet 10. This protrusion 11 is formed by deforming the metal sheet 10 entirely in its sheet-thickness direction. That is, the protrusion 11 is formed integrally with the front surface 10a and rear surface 10b of the metal sheet 10.

In addition, the cross section of the protrusion 11 perpendicular to the lengthwise direction is approximately triangular. One vertex of the triangle forms the end of the protrusion 11. This end extends linearly.

The elastically deformable portion 12 is provided annularly in such a manner that the elastically deformable portion 12 surrounds the periphery of the protrusion 11. The protrusion 11 and the elastically deformable portion 12 are formed continuously. Specifically, the outer peripheral edge of the protrusion 11 and the inner peripheral edge of the elastically deformable portion 12 are seamlessly and smoothly connected.

The elastically deformable portion 12 protrudes outward from the rear surface 10b of the metal sheet 10. In other words, the elastically deformable portion 12 protrudes from the rear surface 10b of the metal sheet 10 in a direction away from the metal sheet 20. The direction in which the protrusion 11 protrudes from the metal sheet 10 and the direction in which the elastically deformable portion 12 protrudes from the metal sheet 10 are mutually opposite directions. The elastically deformable portion 12 is formed by deforming the metal sheet 10 entirely in its sheet-thickness direction. In addition, the cross section of the elastically deformable portion 12 perpendicular to the circumferential direction is approximately triangular. Since the elastically deformable portion 12 is formed in the manner described above, the elastically deformable portion 12 is elastically deformable in the sheet-thickness direction of the metal sheet 10.

As illustrated in FIGS. 1 and 2, the metal sheet 20 includes a protrusion 21 and an elastically deformable portion 22. The protrusion 21 and the elastically deformable portion 22 are provided in an area of the metal sheet 20 where the metal sheet 20 faces the metal sheet 10.

As illustrated in FIG. 3, the metal sheet 20 has a front surface 20a, a rear surface 20b, and a screw through hole 20c. The front surface 20a is a facing surface facing the front surface 10a of the metal sheet 10. The rear surface 20b is a surface positioned on a side opposite to the front surface 20a. The screw through hole 20c is a so-called clearance hole penetrating the metal sheet 20 in the sheet-thickness direction. That is, the screw through hole 20c is opened at the front surface 20a and the rear surface 20b. This screw through hole 20c corresponds to the screw hole 10c, and the screw 51 can penetrate the screw through hole 20c.

The protrusion 21 protrudes outward from the front surface 20a of the metal sheet 20. In other words, the protrusion 21 protrudes toward the metal sheet 10 from the front surface 20a of the metal sheet 20. This protrusion 21 is formed by deforming the metal sheet 20 entirely in its sheet-thickness direction. That is, the protrusion 21 is formed integrally with the front surface 20a and rear surface 20b of the metal sheet 20.

In addition, the cross section of the protrusion 21 perpendicular to the lengthwise direction is approximately triangular. One vertex of the triangle forms the end of the protrusion 21. This end extends linearly.

The elastically deformable portion 22 is provided annularly in such a manner that the elastically deformable portion 22 surrounds the periphery of the protrusion 21. The protrusion 21 and the elastically deformable portion 22 are formed continuously. Specifically, the outer peripheral edge of the protrusion 21 and the inner peripheral edge of the elastically deformable portion 22 are seamlessly and smoothly connected.

The elastically deformable portion 22 protrudes outward from the rear surface 20b of the metal sheet 20. In other words, the elastically deformable portion 22 protrudes from the rear surface 20b of the metal sheet 20 in a direction away from the metal sheet 10. The direction in which the protrusion 21 protrudes from the metal sheet 20 and the direction in which the elastically deformable portion 22 protrudes from the metal sheet 20 are mutually opposite directions. The elastically deformable portion 22 is formed by deforming the metal sheet 20 entirely in its sheet-thickness direction. In addition, the cross section of the elastically deformable portion 22 perpendicular to the circumferential direction is approximately triangular. Since the elastically deformable portion 22 is formed in the manner described above, the elastically deformable portion 22 is elastically deformable in the sheet-thickness direction of the metal sheet 20.

Then, the metal sheet 10 and the metal sheet 20 are arranged in such a manner that the end of the protrusion 11 and the end of the protrusion 21 cross each other.

Next, operation to fasten the structure according to the first embodiment is explained using FIG. 3.

First, as illustrated in FIG. 3A, the front surface 10a of the metal sheet 10 and the front surface 20a of the metal sheet 20 are arranged to face each other. That is, the metal sheets 10 and 20 are arranged in such a manner that the end of the protrusion 11 and the end of the protrusion 21 cross.

Next, as illustrated in FIG. 3B, the screw 51 is screwed through the screw through hole 20c of the metal sheet 20 into the screw hole 10c of the metal sheet 10. As a result of this, the metal sheet 10 and the metal sheet 20 are fastened with the screw 51. At this time, the end of the protrusion 11 and the end of the protrusion 21 contact each other, and pressure is concentrated in a minute area. Because of this, the insulating coatings at the two ends are destroyed, and the base materials at the two ends contact each other. As a result, the base material at the protrusion 11 and the base material at the protrusion 21 get electrically connected. Therefore, a route of noise current or leakage current is ensured between the metal sheets 10 and 20.

In addition, when the metal sheets 10 and 20 get fastened as described above, the elastically deformable portion 12 elastically deforms when the protrusion 11 is pressed toward the rear surface 10b. In addition, the elastically deformable portion 22 elastically deforms when the protrusion 21 is pressed toward the rear surface 20b.

Here, if the screw 51 loosens for some reason, and the fastening force gets lowered, a gap is created between the protrusions 11 and 21 undesirably, and the electrical connection is lost undesirably. However, the elastically deformable portions 12 and 22 are included in the structure according to the first embodiment. Accordingly, the contact between the protrusions 11 and 21 can be maintained using elastic deformation of the elastically deformable portions 12 and 22, that is, using restoring forces of the elastically deformable portions 12 and 22 to return to their original shapes (positions). Because of this, even when the screw 51 loosens undesirably, the electrical connection between the metal sheets 10 and 20 can be maintained, and the influence of noise current or leakage current can be prevented.

As described above, the structure according to the first embodiment is a structure formed by placing, one on another in the sheet-thickness direction, a plurality of the metal sheets 10 and 20 in which electrically conductive base materials are covered with insulating coatings, the structure including: the first protrusion 11 provided on the first metal sheet 10 of the metal sheets 10 and 20 that are adjacent to each other and are fastened together with the screw 51, the first protrusion 11 protruding toward the second metal sheet 20; the first elastically deformable portion 12 provided on the first metal sheet 10 in such a manner that the first elastically deformable portion 12 surrounds the periphery of the first protrusion 11, the first elastically deformable portion 12 being elastically deformable at the time of the fastening with the screw 51; the second protrusion 21 disposed on the second metal sheet 20 in such a manner that the second protrusion 21 protrudes toward the first metal sheet 10, and crosses the first protrusion 11; and the second elastically deformable portion 22 provided on the second metal sheet 20 in such a manner that the second elastically deformable portion 22 surrounds the periphery of the second protrusion 21, the second elastically deformable portion 22 being elastically deformable at the time of the fastening with the screw 51. The end of the first protrusion 11 and the end of the second protrusion 21 contact each other at the time of the fastening with the screw 51. Because of this, the structure according to the first embodiment can ensure electrical connection between the base materials of the metal sheets 10 and 20 even when the screw 51 loosens undesirably. In addition, the structure according to the first embodiment does not require a special screw, washer, or the like for electrically connecting the base materials of the metal sheets 10 and 20 with each other.

### Second Embodiment.

A structure according to a second embodiment is explained using FIGS. 4 and 5. Note that constituent elements having functions similar to those of constituent elements explained in the first embodiment described above are given identical reference signs, and explanation thereof is omitted.

First, the configuration of the structure according to the second embodiment is explained using FIG. 4. FIG. 4 is schematic configuration diagrams of the structure according to the second embodiment.

As illustrated in FIG. 4, the structure according to the second embodiment includes an elastically deformable portion 13 instead of the elastically deformable portion 12 of the metal sheet 10.

As illustrated in FIG. 4B, the elastically deformable portion 13 is provided annularly in such a manner that the elastically deformable portion 13 surrounds the periphery of a protrusion 11. The protrusion 11 and the elastically deformable portion 12 are formed continuously. Specifically, the outer peripheral edge of the protrusion 11 and the inner peripheral edge of the elastically deformable portion 12 are seamlessly and smoothly connected.

The elastically deformable portion 13 protrudes outward from a rear surface 10b of a metal sheet 10. In other words, the elastically deformable portion 13 protrudes from the rear surface 10b of the metal sheet 10 in a direction away from a metal sheet 20. The elastically deformable portion 13 is formed by deforming the metal sheet 10 entirely in its sheet-thickness direction. Since the elastically deformable portion 12 is formed in the manner described above, the elastically deformable portion 12 is elastically deformable in the sheet-thickness direction of the metal sheet 10.

In addition, a cross-sectional shape of the elastically deformable portion 13 perpendicular to the lengthwise direction of the end of the protrusion 11 is asymmetric about the end on both sides of the end. For example, one side of the elastically deformable portion 13 relative to the end of the protrusion 11 as the center has one portion projecting toward the rear surface 10b. In contrast, the other side of the elastically deformable portion 13 relative to the end of the protrusion 11 as the center has one portion projecting toward the rear surface 10b and one portion projecting toward a front surface 10a. At this time, the portion projecting toward the front surface 10a is disposed on the outer side of the metal sheet 10 relative to the portion projecting toward the rear surface 10b.

In this manner, the cross-sectional shape of the elastically deformable portion 13 perpendicular to the lengthwise direction of the end of the protrusion 11 is asymmetric about the end on both sides of the end. Thereby, a difference can be generated between elastic deformation amounts of the one side and the other side relative to the end of the protrusion 11 as the center. Specifically, the other side of the elastically deformable portion 13 relative to the end of the protrusion 11 as the center has a shape which is more complex than the shape of the one side of the elastically deformable portion 13 relative to the end of the protrusion 11 as the center. Because of this, the elastic deformation amount of the other side becomes greater than the elastic deformation amount of the one side.

Next, operation to fasten the structure according to the second embodiment is explained using FIG. 5. FIG. 5 is drawings illustrating operation to fasten the structure according to the second embodiment. Note that the metal sheet 20 is omitted in FIG. 5B.

First, as illustrated in FIG. 5A, the front surface 10a of the metal sheet 10 and a front surface 20a of the metal sheet 20 are arranged to face each other. That is, the metal sheets 10 and 20 are arranged in such a manner that the end of the protrusion 11 and the end of a protrusion 21 cross.

Next, as illustrated in FIG. 5B, a screw 51 is screwed through a screw through hole 20c of the metal sheet 20 into a screw hole 10c of the metal sheet 10. As a result of this, the metal sheet 10 and the metal sheet 20 are fastened with the screw 51. At this time, the end of the protrusion 11 and the end of the protrusion 21 contact each other, and pressure is concentrated in a minute area. In addition, the elastic deformation amount of the other side of the elastically deformable portion 13 becomes greater than the elastic deformation amount of the one side. Because of this, the end position of the protrusion 11 shifts toward the other side. That is, the end of the protrusion 11 moves along the lengthwise direction of the end while remaining in contact with the end of the protrusion 21. Along with this, the insulating coatings at the two ends are destroyed sufficiently, and the base materials at the two ends contact each other. As a result, the base material at the protrusion 11 and the base material at the protrusion 21 get electrically connected. Therefore, a route of noise current or leakage current is ensured between the metal sheets 10 and 20.

In addition, when the metal sheets 10 and 20 get fastened as described above, the elastically deformable portion 13 elastically deforms when the protrusion 11 is pressed toward the rear surface 10b. In addition, an elastically deformable portion 22 elastically deforms when the protrusion 21 is pressed toward a rear surface 20b.

Here, if the screw 51 loosens for some reason, and the fastening force gets lowered, a gap is created between the protrusions 11 and 21 undesirably, and the electrical connection is lost undesirably. However, the elastically deformable portions 13 and 22 are included in the structure according to the second embodiment. Accordingly, the contact between the protrusions 11 and 21 can be maintained using elastic deformation of the elastically deformable portions 13 and 22, that is, using restoring forces of the elastically deformable portions 13 and 22 to return to their original shapes (positions). Because of this, even when the screw 51 loosens undesirably, the electrical connection between the metal sheets 10 and 20 can be maintained, and the influence of noise current or leakage current can be prevented.

Note that, whereas the cross-sectional shape of the elastically deformable portion 13 of the metal sheet 10 is asymmetric in the structure according to the second embodiment, the cross-sectional shape of the elastically deformable portion 22 of the metal sheet 20 may be asymmetric.

As described above, in the structure according to the second embodiment, the cross-sectional shape of the elastically deformable portion 13 perpendicular to the lengthwise direction of the end of the protrusion 11 is asymmetric about the end on both sides of the end. Because of this, the structure according to the second embodiment enables effective peeling of the insulating coatings between the end of the elastically deformable portion 13 and the end of the elastically deformable portion 22.

In addition, in the structure according to the second embodiment, the end of the protrusion 11 moves toward a side of the end where an amount of deformation of the elastically deformable portion 13 is greater. Because of this, the structure according to the second embodiment can increase the peeling areas of the insulating coatings, and can enhance electrical connectivity.

Furthermore, in the structure according to the second embodiment, the end of the protrusion 11 moves along the lengthwise direction of the end of the protrusion 21. Because of this, the structure according to the second embodiment can maintain contact between the end of the protrusion 11 and the end of the protrusion 21 for a longer time and over a larger portion. As a result, the structure according to the second embodiment can increase the peeling areas of the insulating coatings.

### Third Embodiment.

A structure according to a third embodiment is explained using FIGS. 6 and 7. Note that constituent elements having functions similar to those of constituent elements explained in the first embodiment described above are given identical reference signs, and explanation thereof is omitted.

First, the configuration of the structure according to the third embodiment is explained using FIG. 6. FIG. 6 is schematic configuration diagrams of the structure according to the third embodiment.

As illustrated in FIG. 6, the structure according to the third embodiment includes a plurality of pairs of a protrusion 11 and an elastically deformable portion 12, and one pair of a protrusion 23 and an elastically deformable portion 24. FIG. 6 illustrates an example in which the structure according to the third embodiment includes four pairs of the protrusion 11 and the elastically deformable portion 12, and one pair of the protrusion 23 and the elastically deformable portion 24.

As illustrated in FIG. 6, the respective pairs of the protrusion 11 and the elastically deformable portion 12 are arranged at equal angular intervals about a screw hole 10c and a screw 51. In contrast, the protrusion 23 and the elastically deformable portion 24 are formed in circular shapes whose centers are at a screw through hole 20c and the screw 51. The four pairs of the protrusion 11 and the elastically deformable portion 12 and the one pair of the protrusion 23 and the elastically deformable portion 24 face each other in the sheet-thickness direction.

Specifically, the protrusion 23 protrudes outward from a front surface 10a of a metal sheet 20. In other words, the protrusion 23 protrudes toward a metal sheet 10 from a front surface 20a of the metal sheet 20. This protrusion 11 is formed by deforming the metal sheet 10 entirely in its sheet-thickness direction. That is, the protrusion 11 is formed integrally with the front surface 10a and rear surface 10b of the metal sheet 10.

In addition, the cross section of the protrusion 23 perpendicular to the lengthwise direction is approximately triangular. One vertex of the triangle forms the end of the protrusion 23. This end is formed in a circular shape whose center is at the screw through hole 20c and the screw 51.

The elastically deformable portion 24 is provided in such a manner that the elastically deformable portion 24 surrounds the protrusion 23. This elastically deformable portion 24 is disposed on the radially inner side and radially outer side of the protrusion 23. That is, the elastically deformable portion 24 is disposed in such a manner that the elastically deformable portion 24 sandwiches the protrusion 23 from both sides as seen in the radial direction.

The elastically deformable portion 24 protrudes outward from a rear surface 20b of the metal sheet 20. In other words, the elastically deformable portion 24 protrudes from the rear surface 10b of the metal sheet 20 in a direction away from the metal sheet 20. The direction in which the protrusion 23 protrudes from the metal sheet 20 and the direction in which the elastically deformable portion 24 protrudes from the metal sheet 10 are mutually opposite directions. The elastically deformable portion 24 is formed by deforming the metal sheet 20 entirely in its sheet-thickness direction. In addition, the cross section of the elastically deformable portion 24 perpendicular to the circumferential direction is approximately triangular. Since the elastically deformable portion 24 is formed in the manner described above, the elastically deformable portion 24 is elastically deformable in the sheet-thickness direction of the metal sheet 20.

In this manner, the structure according to the third embodiment includes the four pairs of the protrusion 11 and the elastically deformable portion 12 for the one pair of the protrusion 23 and the elastically deformable portion 24. Thereby, the probability that the insulating coatings get destroyed, and electrically connected can be enhanced by 16 times as compared to a case where one pair of the protrusion 11 and the elastically deformable portion 12 is included for one pair of a protrusion 21 and an elastically deformable portion 22. In addition, the structure according to the third embodiment can reduce the value of resistance between the metal sheets 10 and 20 in a state where they are electrically connected to one fourth of that in the above case. Furthermore, the structure according to the third embodiment can stabilize the metal sheets 10 and 20 at the time of the fastening. Because of this, the structure can enhance the precision of assembly of the metal sheets 10 and 20.

In addition, the structure according to the third embodiment may adopt a configuration illustrated in FIG. 7. FIG. 7 is a drawing of the second metal sheet 20 in the structure according to the third embodiment as seen from the rear side. As illustrated in FIG. 7, there are no problems even if, in the structure according to the third embodiment, the number of pairs of the protrusion 11 and the elastically deformable portion 12 and the number of pairs of the protrusion 21 and the elastically deformable portion 22 are set to the same number which is greater than one, and a pair in the metal sheet 10 and a pair in the metal sheet 20 are caused to face each other. Even when such a configuration is adopted, advantages similar to those described above can be attained.

Note that, while the protrusion 23 and the elastically deformable portion 24 of the metal sheet 20 are formed in a circular shape in the structure according to the third embodiment, there are no problems even if the protrusion 11 and the elastically deformable portion 12 of the metal sheet 10 are formed in a circular shape.

As described above, the structure according to the third embodiment includes the plurality of pairs of the protrusion 11 and the elastically deformable portion 12, and the one pair of the protrusion 23 and the elastically deformable portion 24, and each pair of the protrusion 11 and the elastically deformable portion 12 and the pair of the protrusion 23 and the elastically deformable portion 24 are caused to face each other. Because of this, the structure according to the third embodiment enables effective peeling of the insulating coatings between the end of the elastically deformable portion 12 and the end of the elastically deformable portion 24.

In addition, in the structure according to the third embodiment, the protrusion 23 and the elastically deformable portion 24 are formed in circular shapes whose centers are at the screw 51. Because of this, the structure according to the third embodiment can stabilize the metal sheets 10 and 20 at the time of the fastening. As a result, the structure according to the third embodiment can enhance the precision of assembly of the metal sheets 10 and 20.

In addition, in the structure according to the third embodiment, the number of pairs of the protrusion 11 and the elastically deformable portion 12 and the number of pairs of the protrusion 21 and the elastically deformable portion 22 are set to the same number which is greater than one, and a pair of the protrusion 11 and the elastically deformable portion 12 and a pair of the protrusion 21 and the elastically deformable portion 22 are caused to face each other. Because of this, the structure according to the third embodiment enables effective peeling of the insulating coatings between the end of the elastically deformable portion 12 and the end of the elastically deformable portion 22.

Furthermore, in the structure according to the third embodiment, the respective pairs of the protrusion 11 and the elastically deformable portion 12 are arranged at equal angular intervals about the fastening member. Because of this, the structure according to the third embodiment can stabilize the metal sheets 10 and 20 at the time of the fastening. As a result, the structure according to the third embodiment can enhance the precision of assembly of the metal sheets 10 and 20.

### Fourth Embodiment.

A structure according to a fourth embodiment is explained using FIG. 8. FIG. 8 is a schematic configuration diagram of the structure according to the fourth embodiment. Note that constituent elements having functions similar to those of constituent elements explained in the first embodiment described above are given identical reference signs, and explanation thereof is omitted.

As illustrated in FIG. 8, the structure according to the fourth embodiment includes a metal sheet 30 in addition to metal sheets 10 and 20. This structure according to the fourth embodiment is formed by placing the metal sheets 10, 20, and 30 one on another in order in the sheet-thickness direction. A front surface 10a of the metal sheet 10 and a front surface 20a of a metal sheet 20 face each other, and a rear surface 20b of the metal sheet 20 and a front surface 30a of the metal sheet 30 face each other. Because of this, the rear surface 20b and the front surface 30a are included in facing surfaces.

The metal sheet 20 includes a protrusion 25 and an elastically deformable portion 26. The protrusion 25 and the elastically deformable portion 26 are provided in an area of the metal sheet 20 where the metal sheet 20 faces the metal sheet 30.

The protrusion 25 protrudes outward from the rear surface 20b of the metal sheet 20. In other words, the protrusion 25 protrudes toward the metal sheet 30 from the rear surface 20b of the metal sheet 20. This protrusion 25 is formed by deforming the metal sheet 20 entirely in its sheet-thickness direction. That is, the protrusion 25 is formed integrally with the front surface 20a and rear surface 20b of the metal sheet 20.

In addition, the cross section of the protrusion 25 perpendicular to the lengthwise direction is approximately triangular. One vertex of the triangle forms the end of the protrusion 25. This end extends linearly.

The elastically deformable portion 26 is provided annularly in such a manner that the elastically deformable portion 26 surrounds the periphery of the protrusion 25. The protrusion 25 and the elastically deformable portion 26 are formed continuously. Specifically, the outer peripheral edge of the protrusion 25 and the inner peripheral edge of the elastically deformable portion 26 are seamlessly and smoothly connected.

The elastically deformable portion 26 protrudes outward from the front surface 20a of the metal sheet 20. In other words, the elastically deformable portion 26 protrudes from the front surface 20a of the metal sheet 20 in a direction away from the metal sheet 30. The direction in which the protrusion 25 protrudes from the metal sheet 20 and the direction in which the elastically deformable portion 26 protrudes from the metal sheet 20 are mutually opposite directions. The elastically deformable portion 26 is formed by deforming the metal sheet 20 entirely in its sheet-thickness direction. In addition, the cross section of the elastically deformable portion 26 perpendicular to the circumferential direction is approximately triangular. Since the elastically deformable portion 26 is formed in the manner described above, the elastically deformable portion 26 is elastically deformable in the sheet-thickness direction of the metal sheet 20.

In contrast, the metal sheet 30 includes a protrusion 31 and an elastically deformable portion 32. The protrusion 31 and the elastically deformable portion 32 are provided in an area of the metal sheet 30 where the metal sheet 30 faces the metal sheet 20.

The metal sheet 30 has the front surface 30a, a rear surface 30b, and a screw through hole 30c. The front surface 30a is a facing surface facing the metal sheet 20. The rear surface 30b is a surface positioned on a side opposite to the front surface 30a. The screw through hole 30c is a so-called clearance hole penetrating the metal sheet 30 in the sheet-thickness direction. That is, the screw through hole 30c is opened at the front surface 30a and the rear surface 30b. This screw through hole 30c corresponds to a screw hole 10c and a screw through hole 20c, and a screw 51 can penetrate the screw through hole 30c.

The protrusion 31 protrudes outward from the front surface 10a of the metal sheet 30. In other words, the protrusion 31 protrudes toward the metal sheet 20 from the front surface 10a of the metal sheet 30. This protrusion 31 is formed by deforming the metal sheet 30 entirely in its sheet-thickness direction. That is, the protrusion 31 is formed integrally with the front surface 30a and rear surface 30b of the metal sheet 30.

In addition, the cross section of the protrusion 31 perpendicular to the lengthwise direction is approximately triangular. One vertex of the triangle forms the end of the protrusion 31. This end extends linearly.

The elastically deformable portion 32 is provided annularly in such a manner that the elastically deformable portion 32 surrounds the periphery of the protrusion 31. The protrusion 31 and the elastically deformable portion 32 are formed continuously. Specifically, the outer peripheral edge of the protrusion 31 and the inner peripheral edge of the elastically deformable portion 32 are seamlessly and smoothly connected.

The elastically deformable portion 32 protrudes outward from the rear surface 30b of the metal sheet 30. In other words, the elastically deformable portion 32 protrudes from the rear surface 30b of the metal sheet 30 in a direction away from the metal sheet 20. The direction in which the protrusion 31 protrudes from the metal sheet 10 and the direction in which the elastically deformable portion 32 protrudes from the metal sheet 10 are mutually opposite directions. The elastically deformable portion 32 is formed by deforming the metal sheet 30 entirely in its sheet-thickness direction. In addition, the cross section of the elastically deformable portion 32 perpendicular to the circumferential direction is approximately triangular. Since the elastically deformable portion 32 is formed in the manner described above, the elastically deformable portion 32 is elastically deformable in the sheet-thickness direction of the metal sheet 30.

Then, the first metal sheet 20 and the second metal sheet 30 are arranged in such a manner that the end of the protrusion 25 and the end of the protrusion 31 cross each other.

As described above, the structure according to the fourth embodiment is a structure formed by placing, one on another in the sheet-thickness direction, a plurality of the metal sheets 10, 20, and 30 in which electrically conductive base materials are covered with insulating coatings, the structure including: the first protrusion 25 provided on the first metal sheet 20 of the metal sheets 20 and 30 that are adjacent to each other and are fastened together with the screw 51, the first protrusion 25 protruding toward the second metal sheet 30; the first elastically deformable portion 26 provided on the first metal sheet 20 in such a manner that the first elastically deformable portion 26 surrounds the periphery of the first protrusion 25, the first elastically deformable portion 26 being elastically deformable at the time of the fastening with the screw 51; the second protrusion 31 disposed on the second metal sheet 30 in such a manner that the second protrusion 31 protrudes toward the first metal sheet 20, and crosses the first protrusion 25; and the second elastically deformable portion 32 provided on the second metal sheet 30 in such a manner that the second elastically deformable portion 32 surrounds the periphery of the second protrusion 31, the second elastically deformable portion 32 being elastically deformable at the time of the fastening with the screw 51. The end of the first protrusion 25 and the end of the second protrusion 31 contact each other at the time of the fastening with the screw 51. Because of this, the structure according to the fourth embodiment can ensure electrical connection between the base materials of the metal sheets 20 and 30 even when the screw 51 loosens undesirably. In addition, the structure according to the fourth embodiment does not require a special screw, washer, or the like for electrically connecting the base materials of the metal sheets 30 and 30 with each other.

Note that any combinations of respective embodiments, modifications of any constituent elements in respective embodiments, or omissions of any constituent elements in respective embodiments are possible within the scope of the disclosure.

### INDUSTRIAL APPLICABILITY

By being provided with elastically deformable portions surrounding the peripheries of protrusions, the structure according to the present disclosure can ensure electrical connection between the base materials of metal sheets, and is suited for being used as structures or the like.

### REFERENCE SIGNS LIST

10: Metal sheet; 10a: Front surface; 10b: Rear surface; 10c: Screw hole; 11: Protrusion; 12, 13: Elastically deformable portion; 20: Metal sheet; 20a: Front surface; 20b: Rear surface; 20c: Screw through hole; 21, 23, 25: Protrusion; 22, 24, 26: Elastically deformable portion; 30: Metal sheet; 30a: Front surface; 30b: Rear surface; 30c: Screw through hole; 31: Protrusion; 32: Elastically deformable portion; 51: Screw

## Claims

1. A structure formed by placing a plurality of metal sheets one on another in a sheet-thickness direction, the plurality of metal sheets each having an electrically conductive base material covered with an insulating coating, the structure comprising:
a first protrusion provided on a first metal sheet of the plurality of metal sheets that are adjacent to each other and are fastened together with a fastening member, the first protrusion protruding toward a second metal sheet of the plurality of metal sheets;
a first elastically deformable portion provided on the first metal sheet in such a manner that the first elastically deformable portion surrounds a periphery of the first protrusion, the first elastically deformable portion being elastically deformable at the time of the fastening with the fastening member;
a second protrusion disposed on the second metal sheet in such a manner that the second protrusion protrudes toward the first metal sheet, and crosses the first protrusion; and
a second elastically deformable portion provided on the second metal sheet in such a manner that the second elastically deformable portion surrounds a periphery of the second protrusion, the second elastically deformable portion being elastically deformable at the time of the fastening with the fastening member, wherein
an end of the first protrusion and an end of the second protrusion contact each other at the time of the fastening with the fastening member.

2. The structure according to claim 1, wherein a cross-sectional shape of the first elastically deformable portion perpendicular to a lengthwise direction of the end of the first protrusion is asymmetric about the end on both sides of the end.

3. The structure according to claim 2, wherein the end of the first protrusion moves toward a side of the end of the first protrusion where an amount of deformation of the first elastically deformable portion is greater.

4. The structure according to claim 3, wherein the end of the first protrusion moves along a lengthwise direction of the end of the second protrusion.

5. The structure according to any one of claim 1 to claim 4, comprising:
a plurality of pairs of the first protrusion and the first elastically deformable portion; and
one pair of the second protrusion and the second elastically deformable portion, wherein
each pair of the first protrusion and the first elastically deformable portion and the pair of the second protrusion and the second elastically deformable portion are caused to face each other.

6. The structure according to claim 5, wherein the second protrusion and the second elastically deformable portion are formed in circular shapes whose centers are at the fastening member.

7. The structure according to any one of claim 1 to claim 4, wherein
the number of pairs of the first protrusion and the first elastically deformable portion and the number of pairs of the second protrusion and the second elastically deformable portion are set to the same number which is greater than one, and
a pair of the first protrusion and the first elastically deformable portion and a pair of the second protrusion and the second elastically deformable portion are caused to face each other.

8. The structure according to any one of claim 5 to claim 7, wherein respective pairs of the first protrusion and the first elastically deformable portion are arranged at equal angular intervals about the fastening member.
